# EUROPÄISCHE PATENTSCHRIFT

(11) **EP 3 309 557 B1**
(45) Veröffentlichungstag und Bekanntmachung des Hinweises auf die Patenterteilung: **09.09.2020**
(21) Anmeldenummer: 17198235.8
(22) Anmeldetag: 17.12.2013
(51) Int. Cl.: G01P 3/487, G01D 5/14, G01D 11/24, G01D 5/12, G01R 33/00

(54) **VERFAHREN ZUM HERSTELLEN EINES WINKELSENSORS**
METHOD FOR MANUFACTURING AN ANGLE SENSOR
PROCEDE DE FABRIQUER UN CAPTEUR D'ANGLE

(30) Priorität: 20.12.2012 DE 102012224108; 20.09.2013 DE 102013219018
(43) Veröffentlichungstag der Anmeldung: 18.04.2018
(62) Teilanmeldung aus: 13808001.5
(73) Patentinhaber: Continental Teves AG & Co. OHG, 60488 Frankfurt am Main (DE)
(72) Erfinder: Sticksel, Gerhard, 63571 Gelnhausen-Haitz (DE); Goll, Manfred, 63695 Glauburg (DE); Hilgenberg, Udo, 60439 Frankfurt am Main (DE)

(56) Entgegenhaltungen:
- EP-A2- 1 059 512
- WO-A1-97/36729
- DE-A1- 3 834 649
- DE-A1-102007 034 099
- DE-A1-102007 060 604

## Beschreibung

Die Erfindung betrifft ein Verfahren zum Herstellen eines Winkelsensors.

Aus der WO 2006 / 029 946 A1 ist ein Winkelsensor mit einem Gebermagneten und einer Messschaltung mit einer Auswerteelektronik zur Auswertung einer Winkelposition des Gebermagneten bekannt. Der Gebermagnet weist keine direkte mechanische Verbindung zur Messschaltung auf, so dass der Gebermagnet aus Sicht der Auswerteelektronik über der Messschaltung schwebt.

Aus der EP 1 059 512 A2 ist ein Winkelsensor bekannt, dessen Basis aus Kunststoff besteht und einen Hohlraum zum Aufnehmen des magnetischen Endes einer Magnetwelle aufweist.

Aus der DE 10 2007 034099 A1 ist ein Winkelsensor mit einem ersten Teil, das ein Gehäuse umfasst und einem zweiten Teil, mit einem signalgebenden Element bekannt, wobei der zweite Teil relativ zum Gehäuse bewegbar in einem Lagerraum des Gehäuses gelagert ist.

Es ist Aufgabe der Erfindung, die Herstellung eines Winkelsensors zu verbessern.

Die Aufgabe wird durch die Merkmale des unabhängigen Anspruchs gelöst. Bevorzugte Weiterbildungen sind Gegenstand der abhängigen Ansprüche.

Gemäß einem Aspekt der Erfindung umfasst ein Winkelsensor zum Erfassen eines Drehwinkel basierend auf einer relativen Winkellage eines physikalischen Feldes, umfassend ein erstes Sensorelement und ein zweites Sensorelement, zwischen denen das physikalische Feld übertragbar ist, wobei das erste Sensorelement ein Sackloch umfasst, in dem das zweite Sensorelement drehbar gelagert ist.

Dem angegebenen Winkelsensor liegt die Überlegung zugrunde, dass dieser an einem Fahrzeug zur Erfassung einer relativen Position eines Rades des Fahrzeuges zu seinem Chassis verwendet werden könnte. Auf diese Weise könnte ein aktives Fahrwerkregelsystem realisiert werden, mit dem der klassische Zielkonflikt zwischen sportlicher und komfortabler Fahrwerksabstimmung weiter aufgelöst werden könnte.

Hier zeigt sich jedoch, dass derartige Sensoren sehr fehleranfällig sind und damit eine vergleichsweise kurze Lebensdauer aufweisen. Im Rahmen des angegebenen Winkelsensors wird dabei erkannt, dass eine Hauptursache für die kurze Lebensdauer in den Winkelsensor eindringende Feuchtigkeit ist, die Auswerteschaltung des Winkelsensors beschädigt und funktionsuntüchtig macht. Diese eintretende Feuchtigkeit ist der Ursache geschuldet, dass der Winkelsensor an der Fahrzeugunterseite angebracht direkt von der Straße aufgewirbeltem Schmutz und Feuchtigkeit ausgesetzt ist.

Daher liegt dem angegebenen Winkelsensor die Idee zugrunde diesen und insbesondere seine Auswerteschaltung vor eindringender Feuchtigkeit zu schützen. Dies wird dadurch erreicht, dass der Sensor in zwei Sensorelemente aufgeteilt wird, zwischen denen das physikalische Feld zum Übertragen der Drehwinkelinformation ausgetauscht wird. Dabei wird eines der beiden Sensorelemente mit einem Sackloch ausgebildet in das das andere Sensorelement axial eingeführt und somit darin drehbar aufgenommen ist. Die zuvor genannte Feuchtigkeit könnte dabei zwar in das Sackloch eindringen, das Sackloch selbst isoliert einen Innenraum des entsprechenden Sensorelementes in dem das Sackloch ausgebildet ist gegenüber der Feuchtigkeit, so dass die Feuchtigkeit nicht bin den Innenraum eindringen kann. Eine in diesem Sensorelement aufgenommene Komponente des Drehwinkelsensors, wie beispielsweise eine Auswerteschaltung oder ein Geberelement wäre damit vollständig vor der eindringenden Feuchtigkeit geschützt, so dass ein Ausfall des Winkelsensors aus dieser Ursache her rührend ausgeschlossen werden kann.

In einer Weiterbildung umfasst der angegebene Winkelsensor ein ortsfest im zweiten Sensorelement befestigtes Geberelement zur Abgabe des physikalischen Feldes. Dieses physikalische Feld ist vorzugsweise ein magnetisches Feld, weil dieses durch gängige Gehäuse-Materialien, wie Kunststoff oder Metall hindurchtreten und damit im ersten Sensorelement empfangen werden kann. Dabei kann das zweite Sensorelement selbst ein rotationssymmetrisches Gehäuse umfassen, in dem das Geberelement aufgenommen ist, wobei sich das rotationssymmetrische Gehäuse im oben genannten Sackloch drehen kann.

In einer zusätzlichen Weiterbildung umfasst der angegebene Winkelsensor eine ortsfest im ersten Sensorelement befestigte Auswerteschaltung zum Empfangen des physikalischen Feldes und zur Bestimmung eines vom Drehwinkel abhängigen Ausgangssignals basierend auf dem physikalischen Feld. Diese Auswerteschaltung wäre durch die Aufnahme im ersten Sensorelement aufgrund der oben genannten hermetischen Abriegelung gegenüber der eindringenden Feuchtigkeit vor Verwitterungseffekten geschützt. Prinzipiell könnte jedoch die Auswerteschaltung auch im zweiten Sensorelement angeordnet werden, wobei dann das zuvor genannte Geberelement im ersten Sensorelement angeordnet werden sollte.

In einer anderen Weiterbildung des angegebenen Winkelsensors ist das zweite Sensorelement im ersten Sensorelement im Sackloch axial gelagert. Auf diese Weise kann vermieden werden, dass sich das zweite Sensorelement gegenüber dem ersten Sensorelement axial bewegt und einen axialen Abstand zwischen der Auswerteschaltung und dem Geberelement vergrößert, was in erster Linie zu einer Schwächung des an der Auswerteschaltung ankommenden physikalischen Feldes wie dem magnetischen Feld und damit einer Verschlechterung der Messbedingungen führen würde. Im schlimmsten Fall könnte sogar das zweite Sensorelement aus dem ersten Sensorelement herausfallen.

In einer besonderen Weiterbildung des angegebenen Winkelsensors besteht das erste Sensorelement aus einem vom zweiten Sensorelement verschiedenen Material. Auf diese Weise können verschiedene Laufeigenschaften zwischen den beiden Sensorelementen wie Resistenzen gegen Abrieb und Laufgeräusche an die Einsatzbedingungen beispielsweise in dem oben genannten Fahrzeug angepasst werden.

In einer bevorzugten Weiterbildung des angegebenen Winkelsensors ist das Material wenigstens eines der Sensorelemente mit einem Additiv gefüllt. Im Rahmen dieses Additivs können die Eigenschaften, wie Verschleißfestigkeit, Laufgeräusche, und so weiter an der Schnittstelle zwischen den beiden Sensorelementen an die Betriebsbedingungen angepasst werden.

Das Additiv kann dabei eingerichtet sein, einen Reibbeiwert an der Schnittstelle zwischen den beiden Sensorelementen zu reduzieren. Beispielsweise könnte als Additiv das unter dem Handelsnahmen Teflon bekannte Polytetrafluorethylen verwendet werden.

In einer besonders bevorzugten Weiterbildung des angegebenen Winkelsensors sind die Materialen derart gewählt, dass eine Schnittstelle zwischen beiden Sensoren reibungsarm ist. Weil sich die beiden Sensorelemente reibungsarm ineinander bewegen können Verschleißerscheinungen wie Abrieb minimiert werden. Ferner können bei der Materialwahl auch andere Kriterien, wie beispielsweise eine Selbstschmierung mit berücksichtigt werden.

Gemäß der Erfindung umfasst ein Verfahren zum Herstellen eines der angegebenen Winkelsensoren die Schritte Bereitstellen des zweiten Sensorelementes, und Umspritzen des zweiten Sensorelementes mit einem Material zum Formen eines Gehäuses für das erste Sensorelement. Auf diese Weise lässt sich der angegebene Winkelsensor besonders günstig fertigen.

In einer Weiterbildung des angegebenen Verfahrens wird ein Trennmittel auf das zweite Sensorelement vor dem Umspritzen des zweiten Sensorelementes aufgetragen. Dieses Trennmittel, wie beispielsweise ein flüssiges Werkzeugtrennmittel oder ein festes Trennmittel wie ein Lack sein. Mittels des Trennmittels könnten die beiden Sensorelemente nach dem Umspritzen nicht nur voneinander getrennt gehalten, sondern auch, die Reibung zwischen den beiden Sensorelementen im Betrieb verringert werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden, wobei:
Fig. 1 in einer schematischen Ansicht ein Fahrzeug mit einem Fahrwerksregelsystem,
Fig. 2 einen Winkelsensor zum Erfassen einer Beschleunigung zwischen einem Rad und einem Fahrwerk in dem Fahrzeug der Fig. 1,
Fig. 3 einen alternativen Winkelsensor zum Erfassen einer Beschleunigung zwischen einem Rad und einem Fahrwerk in dem Fahrzeug der Fig. 1 zeigen.

In den Figuren werden gleiche technische Elemente mit gleichen Bezugszeichen versehen und nur einmal beschrieben.

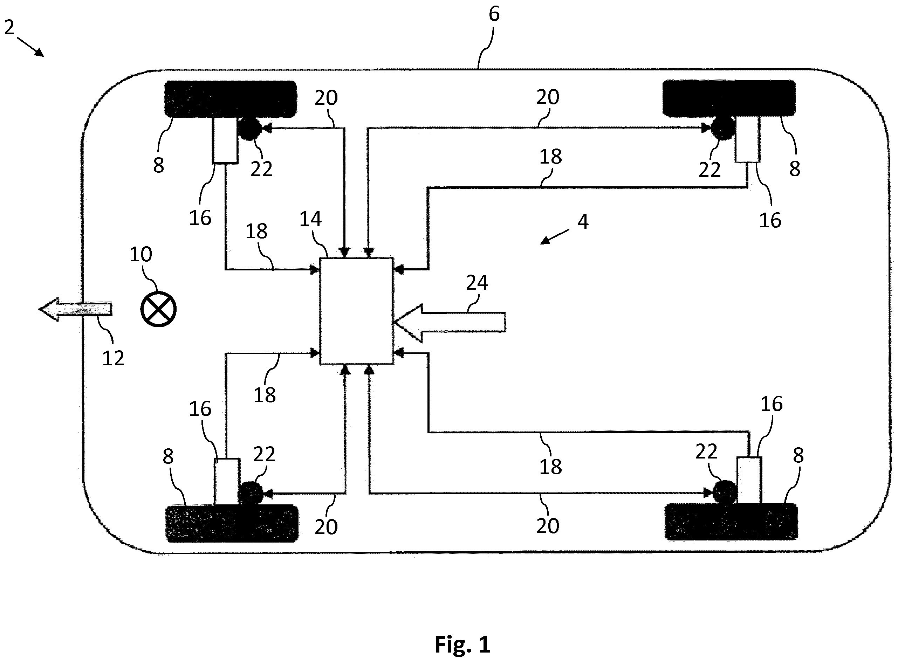

Es wird auf Fig. 1 Bezug genommen, die in einer schematischen Ansicht ein Fahrzeug 2 mit einem Fahrwerksregelsystem 4 zeigt.

Im Rahmen dieses Fahrwerksregelsystem 4 sollen Hub-, Nick und Wankbewegungen eines Chassis 6 gegenüber einer nicht weiter dargestellten Straße, auf der ortsfest Räder 8 des Fahrzeuges 2 in einer Hochachse 10 ortsfest rollen minimiert werden, um die Fahreigenschaften des Fahrzeuges 2 beim Fahren in einer Fahrtrichtung 12 zu verbessern.

Dazu weist das Fahrwerksregelsystem in einer beispielsweise aus der DE 10 2005 060 173 A1 bekannten Weise eine Steuervorrichtung 14 auf, die in der vorliegenden Ausführung aus an jedem Rad 8 angeordneten Winkelsensoren 16 Drehwinkel 18 empfängt, die eine relative Lage des entsprechenden Rades 8 gegenüber dem Chassis 6 beschreiben. Basierend auf den Differenzen dieser Drehwinkel 18 bestimmt die Steuervorrichtung 14, ob das Chassis 6 sich in der Hochachse 10 bewegt, also eine Hubbewegung ausführt, oder ob das Chassis 6 wankt oder nickt und steuert. In diesem Fall berechnet die Steuervorrichtung 14 eine dieser Hub-, Wank- und/oder Nickbewegung entgegenwirkenden Gegenbewegung und steuert mit geeigneten Steuersignalen 20 an den Rädern 8 angeordnete aktive Federbeine 22 an, um mit dem Chassis 6 diese Gegenbewegung auszugleichen. Als aktive Federbeine 22 können beispielsweise die aus der DE 101 22 542 B4 bekannten Federbeine verwendet werden.

Um durch die Straßenlage bedingte Hub-, Wank- und/oder Nickbewegungen beispielsweise bei einer Kurvenfahrt zu berücksichtigen, kann der Steuervorrichtung ein geeigneter Sollwert 24 zugeführt werden.

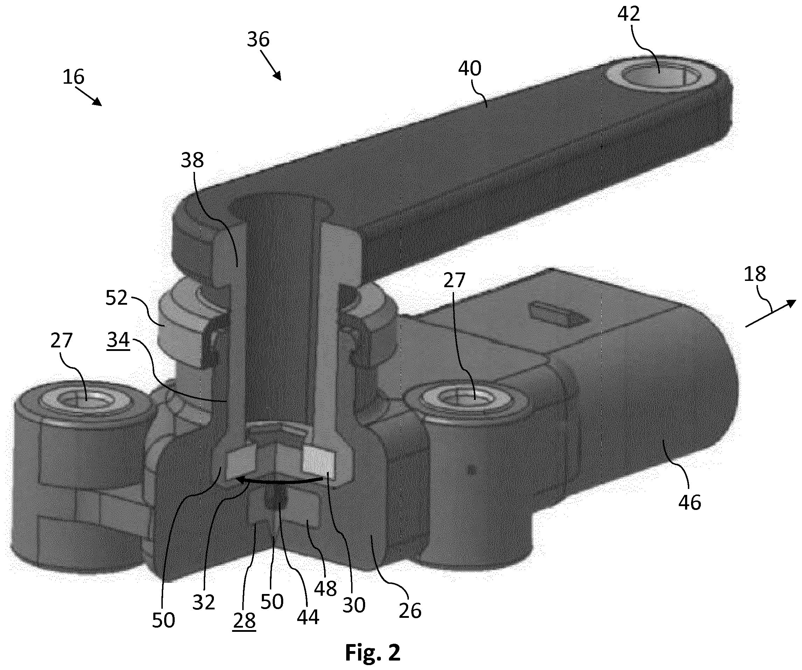

Es wird auf Fig. 2 Bezug genommen, in der ein Beispiel für einen Winkelsensor 16 aus Fig. 1 gezeigt ist.

Der Winkelsensor 16 weist in der vorliegenden Ausführung einen in der Hochachse 10 ortsfest mit dem Chassis 6 verbindbares erstes Sensorelement in Form eines Schaltungsgehäuses 26 auf. Dazu sind an dem Schaltungsgehäuse 26 Befestigungsbohrungen 27 ausgebildet, durch das ein nicht weiter gezeigtes Befestigungsmittel, wie beispielsweise eine Schraube geführt werden kann. In dem Schaltungsgehäuse 26 ist eine Auswerteschaltung 28 eingehaust, die von einem noch zu beschreibenden Geberelement in Form eines Magneten 30 ein physikalisches Feld in Form eines Magnetfeldes 32 empfängt. In einem Sackloch 34 des Schaltungsgehäuses 26 ist ein zweites Sensorelement 36 in Form eines Gebergehäuses 38 drehbar aufgenommen, in dem der Magnet 30 an einem axialen Ende eingehaust ist. Vom dem Magneten 30 gegenüberliegenden axialen Ende des Gebergehäuses 38 ragt rechtwinklig ein Hebel 40 ab, an dessem radialen Ende eine Befestigungsbohrung 42 ausgebildet ist, an der der Winkelsensor 16 in der Hochachse 10 ortsfest mit einem der Räder 6 verbindbar ist.

Bewegt sich das entsprechende Rad 6 in der Hochachse 10 gegenüber dem Chassis 6, so bewegt das Rad 6 auch den Hebel 40 und verdreht damit das Gebergehäuse 38 gegenüber dem Schaltungsgehäuse 26 mit dem zu übertragenden Drehwinkel 16. Damit bewegt sich auch Magnetfeld 32 gegenüber der Auswerteschaltung 28 mit dem Drehwinkel 16, was von dieser messtechnisch beispielsweise über ein an sich bekanntes Hall-Element 44 in der Auswerteschaltung 28 erfasst und an einer Ausgabeschnittstelle 46 in einem den Drehwinkel 16 tragenden nicht weiter dargestellten Ausgabesignal in der in Fig. 1 gezeigten Weise an die Steuervorrichtung 14 übertragen werden kann.

In der vorliegenden Ausführung ist das Hall-Element 44 in der Auswerteschaltung 28 mit weiteren nicht dargestellten Elementen, wie beispielsweise einem Signalauswertechip in einer Schutzmasse 48 eingehaust. Die Auswerteschaltung 48 selbst sowie weitere Komponenten, wie beispielsweise ein nicht weiter dargestellte Signalkabel zum Übertragen des obigen Ausgabesignals an die Ausgabeschnittstelle 46 sind dann in dem Schaltungsgehäuse 26 eingehaust, das in der vorliegenden Ausführung um das Gebergehäuse 38 herum gegossen ist. Dazu werden das Gebergehäuse 38, die Auswerteschaltung 28 und alle eventuell weiteren in dem Schaltungsgehäuse 26 aufzunehmenden Elemente, wie beispielsweise die Befestigungsbohrungen 27 ausbildende Buchsen in einem nicht weiter dargestellten Werkzeug aufgenommen und mit einer das Schaltungsgehäuse 26 ausbildenden Masse, wie beispielsweise einem Kunststoff umspritzt. Auf diese Weise wird das Schaltungsgehäuse 26 automatisch mit dem Sackloch 34 ausgebildet. Dabei wird die das Schaltungsgehäuse 26 ausbildende Masse 26 in einem heißen Zustand um das Gebergehäuse 38 umspritzt, wobei sich im Sackloch 34 zwischen dem Schaltungsgehäuse 26 und dem Gebergehäuse 38 aufgrund einer Schrumpfung beim Abkühlen und/oder Erhärten des Schaltungsgehäuses 26 ein nicht weiter referenzierter Spalt ausbildet. Aufgrund dieses Spaltes entsteht ein Spiel zwischen dem Gebergehäuse 38 und dem Schaltungsgehäuse 26, aufgrund dessen sich das Gebergehäuse 38 im Schaltungsgehäuse 26 drehen kann. Damit die Auswerteschaltung 28 bei der Herstellung des Schaltungsgehäuses 26 in dem Werkzeug gehalten werden kann ist an dieser eine Werkzeugaufnahme 50 ausgebildet.

Um das Gebergehäuse 38 in dem Schaltungsgehäuse 26 auch axial zu halten ist an dem, dem Hebel 40 gegenüberliegenden axialen Ende des Gebergehäuses 38 eine Radialwulst 50 ausgebildet, die das Gebergehäuse 38 axial in dem Schaltungsgehäuse 26 fixiert. Auf diese Weise wird zwischen dem Magneten 30 und der Auswerteschaltung 28 ein konstanter Luftspalt ausgebildet, der eine dauerhaft präzise Auswertung des Drehwinkels 18 basierend auf dem Magnetfeld 32 erlaubt.

Als Material für das Schaltungsgehäuse 26 kann beispielsweise ein Kunststoff verwendet werden, während als Material für das Gebergehäuse 38 ein Metall oder ebenfalls ein Kunststoff verwendet werden kann.

Der oben genannte Spalt zwischen dem Gebergehäuse und dem Schaltungsgehäuse 26 kann in der vorliegenden Ausführung mit einem Dichtring 52 abgedichtet werden.

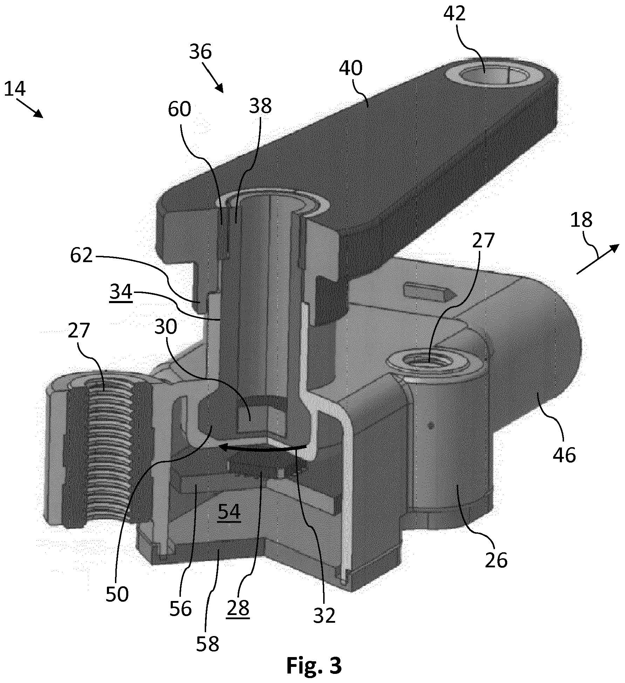

In Fig. 3 ist ein alternativer Winkelsensor 16 gezeigt, der im Wesentlichen auf dem Winkelsensor 16 der Fig. 2 basiert. Nachstehend werden daher nur die Unterscheide zwischen dem Winkelsensor 16 der Fig. 2 und dem Winkelsensor 16 der Fig. 3 beschrieben.

Im Gegensatz zum Winkelsensor 16 der Fig. 3 wird bei der Herstellung des Schaltungsgehäuses 26 des Winkelsensors 14 der Fig. 3 zunächst ein Innenraum 54 des Schaltungsgehäuses 26 beispielsweise durch Umspritzen geformt. Dabei wird eine den Innenraum 54 ausbildende Form gemeinsam mit dem Gebergehäuse 38 und den Buchsen 27, die in der vorliegenden Ausführung ein nicht weiter referenziertes Innengewinde aufweisen können, in dem oben genannten Werkzeug angeordnet und in der oben genannten Weise mit dem das Schaltungsgehäuse 26 ausbildenden Material umspritzt. Im Anschluss wird ein die Auswerteschaltung 28 tragender Trageboden 56 in den Innenraum 54 derart eingesetzt, dass ein die Auswerteschaltung 28 mit einem bestimmten Luftspalt zum Magneten 30 angeordnet ist, und im Schaltungsgehäuse 26 befestigt. Abschließend wird der Innenraum 54 mit einem Deckel 58 verschlossen.

Der Hebel 40 ist in der vorliegenden Ausführung nicht einstückig am Gebergehäuse 38 sondern über eine Klemmbuchse 60 per Presspassung an diesem befestigt. Dabei ist an den Hebel 40 eine Dichtbuchse 62 angeformt, die das Schaltungsgehäuse 26 in einem vorbestimmten Bereich radial überkragt. Auf diese Weise kann auf das optionale Dichtelement 52 der Fig. 3 auch verzichtet werden.

## Patentansprüche

1. Verfahren zum Herstellen eines Winkelsensors (16) zum Erfassen eines Drehwinkels (18) basierend auf einer relativen Winkellage eines Magnetfelds (32) eines Magneten (30), umfassend ein Schaltungsgehäuse (26) und ein Gebergehäuse (38), zwischen denen das Magnetfeld (32) übertragbar ist, wobei der Magnet (30) in dem Gebergehäuse (38) eingehaust ist, wobei das Schaltungsgehäuse (26) ein Sackloch (34) umfasst, in dem das Gebergehäuse (38) drehbar gelagert ist, umfassend die Verfahrensschritte:
- Bereitstellen des Gebergehäuses (38), und
- Umspritzen des Gebergehäuses (38) mit einem Material zum Formen des Schaltungsgehäuses (26).

2. Verfahren nach Anspruch 1, umfassend Auftragen eines Trennmittels auf das Gebergehäuse (38) vor dem Umspritzen des Gebergehäuses (38).

## Claims

1. Method for producing an angle sensor (16) for capturing an angle of rotation (18) on the basis of a relative angular position of a magnetic field (32) of a magnet (30), comprising a circuit housing (26) and a transducer housing (38) between which the magnetic field (32) can be transmitted, wherein the magnet (30) is enclosed in the transducer housing (38), wherein the circuit housing (26) comprises a blind hole (34) in which the transducer housing (38) is rotatably mounted, comprising the method steps of:
- providing the transducer housing (38), and
- encapsulating the transducer housing (38) with a material for forming the circuit housing (26).

2. Method according to Claim 1, comprising applying a release agent to the transducer housing (38) before encapsulating the transducer housing (38).

## Revendications

1. Procédé de fabrication d'un capteur d'angle (16) pour détecter un angle de rotation (18) sur la base d'une position angulaire relative d'un champ magnétique (32) d'un aimant (30), comprenant
un boîtier de circuit (26) et un boîtier de capteur (38) entre lesquels le champ magnétique (32) peut être transmis, l'aimant (30) étant logé dans le boîtier de capteur (38), le boîtier de circuit (26) comprenant un trou borgne (34) dans lequel le boîtier de capteur (38) est supporté de manière rotative, le procédé comprenant les étapes de procédé suivantes :
- fourniture du boîtier de capteur (38), et
- surmoulage du boîtier de capteur (38) avec un matériau pour former le boîtier de circuit (26).

2. Procédé selon la revendication 1, comprenant l'application d'un moyen de séparation sur le boîtier de capteur (38) avant le surmoulage du boîtier de capteur (38).
